# FASCICULE DE BREVET EUROPEEN

(11) **EP 2 167 997 B1**
(45) Date de publication et mention de la délivrance du brevet: **10.08.2016**
(21) Numéro de dépôt: 08805986.0
(22) Date de dépôt: 12.06.2008
(51) Int. Cl.: G02B 1/11, G02C 7/02, C23C 14/32, C03C 17/00

(54) **ARTICLE D'OPTIQUE REVETU D'UN REVETEMENT ANTIREFLET COMPRENANT UNE SOUS-COUCHE PARTIELLEMENT FORMEE SOUS ASSISTANCE IONIQUE ET PROCEDE DE FABRICATION**
BESCHICHTETER OPTISCHER ARTIKEL MIT EINER ANTIREFLEXIONSBESCHICHTUNG, DIE EINE TEILWEISE MIT IONENUNTERSTÜTZUNG GEFORMTE UNTERSCHICHT AUFWEIST, UND HERSTELLUNGSVERFAHREN DAFÜR
OPTICAL ARTICLE COATED WITH AN ANTIREFLECTION COATING COMPRISING A SUBLAYER PARTIALLY FORMED UNDER ION ASSISTANCE AND MANUFACTURING PROCESS

(30) Priorité: 13.06.2007 FR 0755749
(43) Date de publication de la demande: 31.03.2010
(73) Titulaire: Essilor International (Compagnie Générale d'Optique), 94220 Charenton Le Pont (FR)
(72) Inventeur: NOUVELOT, Luc, F-94220 Charenton Le Pont (FR); ROTTE, Johann, F-94220 Charenton Le Pont (FR); SCHERER, Karin, F-94220 Charenton Le Pont (FR); VALLET, Daniel, F-94220 Charenton Le Pont (FR)
(74) Mandataire: Catherine, Alain
(86) Numéro de dépôt international: PCT/FR2008/051051
(87) Numéro de publication internationale: WO 2009/004222

(56) Documents cités:
- EP-A- 1 184 686
- WO-A-02/096627
- FR-A- 2 843 407
- JP-A- 2 230 101
- JP-A- 2004 341 052
- JP-A- 2005 234 188
- JP-A- 2007 065 259
- JP-A- 2007 078 780
- US-A1- 2004 043 259
- US-A1- 2004 121 134

## Description

La présente invention concerne un article d'optique comprenant un substrat revêtu d'un revêtement antireflet comprenant une sous-couche, possédant notamment une résistance à l'abrasion accrue, ainsi qu'un procédé de préparation d'un tel article d'optique.

Dans le domaine de l'optique ophtalmique, il est classique de revêtir une lentille ophtalmique de divers revêtements afin de conférer à cette lentille diverses propriétés mécaniques et/ou optiques. Ainsi, classiquement, on forme sur une lentille ophtalmique successivement des revêtements tels que des revêtements antichocs, anti-abrasion et/ou antireflet.

Un revêtement antireflet se définit comme un revêtement, déposé à la surface d'un article d'optique, qui améliore les propriétés anti-réfléchissantes de l'article d'optique final. Il permet de réduire la réflexion de la lumière à l'interface article-air sur une portion relativement large du spectre visible.

Les revêtements antireflet sont bien connus et comprennent classiquement un empilement monocouche ou multicouche de matériaux diélectriques tels que SiO, SiO₂, Al₂O₃, MgF₂, LiF, Si₃N₄, TiO₂, ZrO₂, Nb₂O₅, Y₂O₃, HfO₂, Sc₂O₃, Ta₂O₅, Pr₂O₃, ou leurs mélanges.

Comme cela est bien connu également, les revêtements antireflet sont, de préférence, des revêtements multicouches comprenant alternativement des couches de haut indice de réfraction et des couches de bas indice de réfraction.

Il est connu d'interposer une sous-couche d'épaisseur relativement importante entre le substrat et les couches de haut indice de réfraction et de bas indice de réfraction du revêtement antireflet dans le but d'améliorer la résistance à l'abrasion et/ou aux rayures dudit revêtement. Cette sous-couche peut comprendre une ou plusieurs couches.

Le dépôt des couches de la sous-couche et de l'empilement antireflet multicouche est conventionnellement réalisé par dépôt en phase vapeur, éventuellement assisté par faisceau ionique. La technique du dépôt sous assistance ionique ou "IAD" (pour Ion Assisted Déposition) est décrite notamment dans la demande de brevet US 2006/017011 et le brevet US 5,268,781. Elle ne nécessite pas de chauffage des substrats, ce qui est intéressant pour le revêtement de substrats thermosensibles tels que des substrats en verre ou en plastique.

L'évaporation sous assistance ionique consiste à déposer un film d'un matériau sur un substrat par évaporation sous vide en bombardant simultanément la surface du substrat avec un faisceau d'ions émis par un canon à ions. Le bombardement ionique provoque un réarrangement atomique dans la couche en cours de dépôt, ce qui augmente sa densité. Outre une densification, l'IAD permet d'améliorer l'adhérence des couches déposées et d'augmenter leur indice de réfraction.

La demande de brevet WO 2005/059603, au nom du déposant, décrit un substrat de lentille ophtalmique revêtu d'un revêtement antireflet multicouche coloré, déposé sans assistance ionique, et d'un revêtement anti-salissures. Le revêtement antireflet est composé d'une sous-couche de silice de 100-110 nm d'épaisseur, et d'une alternance de couches de haut indice de réfraction absorbant dans le visible à base d'oxyde de titane sous-stoechiométrique TiOₓ (x < 2) et de couches de bas indice de réfraction (BI) à base de SiO₂ dopée par 1-5 % en masse d'Al₂O₃, par rapport à la masse totale SiO₂ + Al₂O₃.

Avant le dépôt du revêtement antireflet, la surface du substrat est soumise à un traitement destiné à augmenter l'adhésion de la sous-couche. Cette préparation de surface, nommée IPC (Ion Pre-cleaning), consiste en un pré-nettoyage ionique par bombardement du substrat par des ions argon à l'aide d'un canon à ions.

L'article d'optique obtenu selon l'enseignement de la demande de brevet WO 2005/059603 possède des propriétés de résistance à l'abrasion satisfaisantes, mais qui peuvent toutefois être améliorées.

Le brevet japonais H05-034502 décrit la préparation d'articles d'optique comprenant un revêtement antireflet composé d'une sous-couche laminée d'épaisseur 0,125 λ - 0,8 λ, avec λ = 500 nm et d'un empilement antireflet comprenant une couche de haut indice de réfraction intercalée entre deux couches de bas indice de réfraction.

La sous-couche laminée comprend les trois couches suivantes, toutes déposées sans assistance ionique : une couche de SiO₂ de faible épaisseur (0,05 λ - 0,15 λ) et d'indice de réfraction n = 1,45-1,47, une couche de Ta₂O₅ de très faible épaisseur (0,01 λ - 0,10 λ) et d'indice de réfraction n = 2-2,1, et une couche de SiO₂/Al₂O₃ d'indice de réfraction n = 1,48-1,52 d'épaisseur élevée (0,75 λ - 1,50 λ), ces trois couches étant déposées sur le substrat dans l'ordre dans lequel elles ont été citées.

L'utilisation de cette sous-couche tricouche plutôt qu'une seule couche de SiO₂/Al₂O₃ permet d'améliorer les propriétés de résistance à la chaleur de l'article d'optique. Ce brevet ne s'intéresse pas à l'amélioration de la résistance à l'abrasion.

Les brevets EP 1184685 et EP 1184686 (Hoya Corporation) décrivent un élément d'optique comprenant un substrat en matière plastique revêtu d'une sous-couche de Nb (niobium métal) ou de SiO₂ et d'un empilement antireflet. La sous-couche (uniquement lorsqu'elle est en niobium), et certaines couches de l'empilement antireflet peuvent être déposées par évaporation sous assistance d'ions argon. L'article préparé possède une bonne résistance à la chaleur et aux rayures mais sa résistance à l'abrasion n'a pas été évaluée.

Le brevet FR 2843407 divulge un empilement anti reflet comprenant une surcouche. Le brevet JP 2007 078780 décrit un empilement anti reflet sur une couche anti abrasion.

La présente invention a donc pour objectif de fournir un article d'optique transparent, notamment une lentille ophtalmique, comprenant un substrat en verre minéral ou organique et un revêtement antireflet incluant une sous-couche, lequel a l'avantage de posséder à la fois des propriétés de résistance à l'abrasion et d'adhésion améliorées par rapport aux articles d'optique de l'art antérieur.

Les articles d'optique préparés doivent conserver d'excellentes propriétés de transparence, présenter une bonne résistance à un traitement au trempé dans l'eau chaude suivi d'une sollicitation mécanique de surface, et être exempts de défauts optiques.

Un autre objectif de l'invention est un procédé de préparation d'articles d'optique tels que ci-dessus, qui soit capable de s'intégrer aisément dans le processus classique de fabrication des articles d'optique, et de préférence éviter un chauffage du substrat.

Les présents inventeurs ont trouvé qu'une modification du procédé de formation de la sous-couche du revêtement antireflet permettait d'atteindre tous les objectifs fixés ci-dessus.

Les buts fixés ci-dessus sont donc atteints selon l'invention par un article d'optique à propriétés antireflet, comprenant toutes les caractéristiques récitées dans la revendication 1.

L'invention concerne également un procédé de fabrication d'un tel article d'optique à propriétés antireflet, comprenant au moins les étapes suivantes :
- fournir un article d'optique comprenant toutes les étapes récitées dans la revendication 16.

Les revendications dépendantes définissent des modes de réalisation additionnels.

Dans la présente demande, lorsqu'un article d'optique comprend un ou plusieurs revêtements à sa surface, l'expression "déposer une couche ou un revêtement sur l'article" signifie qu'une couche ou un revêtement est déposé sur la surface à découvert (exposée) du revêtement externe de l'article, c'est-à-dire son revêtement le plus éloigné du substrat.

Un revêtement qui est "sur" un substrat ou qui a été déposé "sur" un substrat est défini comme un revêtement qui (i) est positionné au-dessus du substrat, (ii) n'est pas nécessairement en contact avec le substrat, c'est-à-dire qu'un ou plusieurs revêtements intermédiaires peuvent être disposés entre le substrat et le revêtement en question, et (iii) ne recouvre pas nécessairement le substrat complètement.

Lorsque "une couche 1 est localisée sous une couche 2", on comprendra que la couche 2 est plus éloignée du substrat que la couche 1.

Par "empilement antireflet multicouche," on entend l'empilement multicouche du revêtement antireflet qui est déposé sur la sous-couche du revêtement antireflet. Dans le reste de la demande, il sera simplement appelé "empilement multicouche."

L'article d'optique préparé selon l'invention comprend un substrat, de préférence transparent, en verre organique ou minéral, ayant des faces principales avant et arrière, l'une au moins desdites faces principales comportant un revêtement antireflet comprenant une sous-couche revêtue d'un empilement multicouche, de préférence les deux faces principales. L'empilement multicouche est de préférence directement en contact avec la sous-couche.

Par face arrière (généralement concave) du substrat, on entend la face qui, lors de l'utilisation de l'article, est la plus proche de l'oeil du porteur. Inversement, par face avant (généralement convexe) du substrat, on entend la face qui, lors de l'utilisation de l'article, est la plus éloignée de l'oeil du porteur.

De manière générale, la sous-couche et l'empilement multicouche du revêtement antireflet de l'article d'optique selon l'invention peuvent être déposés sur tout substrat, et de préférence sur des substrats en verre organique, par exemple une matière plastique thermoplastique ou thermodurcissable.

Parmi les matériaux thermoplastiques convenant pour les substrats, on peut citer les (co)polymères (méth)acryliques, en particulier le poly(méthacrylate de méthyle) (PMMA), les (co)polymères thio(méth)acryliques, le polyvinylbutyral (PVB), les polycarbonates (PC), les polyuréthanes (PU), les poly(thiouréthanes), les (co)polymères d'allylcarbonates de polyols, les copolymères thermoplastiques éthylène/acétate de vinyle, les polyesters tels que le poly(téréphtalate d'éthylène) (PET) ou le poly(téréphtalate de butylène) (PBT), les polyépisulfures, les polyépoxydes, les copolymères polycarbonates/polyesters, les copolymères de cyclo-oléfines tels que les copolymères éthylène/norbornène ou éthylène/cyclopentadiène et leurs combinaisons.

Par (co)polymère, on entend un copolymère ou un polymère. Par (méth)acrylate, on entend un acrylate ou un méthacrylate.

Parmi les substrats préférés selon l'invention, on peut citer des substrats obtenus par polymérisation des (métha)crylates d'alkyle, en particulier des (méth)acrylates d'alkyle en C₁-C₄, tels que le (méth)acrylate de méthyle et le (méth)acrylate d'éthyle, des (méth)acrylates aromatiques polyéthoxylés tels que les di(méth)acrylates de bisphénols polyéthoxylés, des dérivés allyles tels que les allylcarbonates de polyols aliphatiques ou aromatiques, linéaires ou ramifiés, des thio(méth)acrylates, des épisulfures et de mélanges précurseurs polythiols/polyisocyanates (pour l'obtention de polythiouréthanes).

Par polycarbonate (PC), on entend au sens de la présente invention aussi bien les homopolycarbonates que les copolycarbonates et les copolycarbonates séquencés. Les polycarbonates sont disponibles dans le commerce, par exemple auprès des sociétés GENERAL ELECTRIC COMPANY sous la marque LEXAN^{®}, TEIJIN sous la marque PANLITE^{®}, BAYER sous la marque BAYBLEND^{®}, MOBAY CHEMICHAL Corp. sous la marque MAKROLON^{®} et DOW CHEMICAL Co. sous la marque CALIBRE^{®}.

Comme exemples de (co)polymères d'allyl carbonates de polyols, on peut citer les (co)polymères d'éthylèneglycol bis (allyl carbonate), de diéthylèneglycol bis 2-méthyl carbonate, de diéthylèneglycol bis (allyl carbonate), d'éthylèneglycol bis (2-chloro allyl carbonate), de triéthylèneglycol bis (allyl carbonate), de 1,3-propanediol bis (allyl carbonate), de propylèneglycol bis (2-éthyl allyl carbonate), de 1,3-butènediol bis (allyl carbonate), de 1,4-butènediol bis (2-bromo allyl carbonate), de dipropylèneglycol bis (allyl carbonate), de triméthylèneglycol bis (2-éthyl allyl carbonate), de pentaméthylèneglycol bis (allyl carbonate), d'isopropylène bisphénol A bis (allyl carbonate).

Les substrats particulièrement recommandés sont les substrats obtenus par (co)polymérisation du bis allyl carbonate du diéthylèneglycol, vendu, par exemple, sous la dénomination commerciale CR-39^{®} par la société PPG Industries (lentilles ORMA^{®} ESSILOR).

Parmi les substrats également particulièrement recommandés, on peut citer les substrats obtenus par polymérisation des monomères thio(méth)acryliques, tels que ceux décrits dans la demande de brevet français FR 2734827.

Bien évidemment, les substrats peuvent être obtenus par polymérisation de mélanges des monomères ci-dessus, ou peuvent encore comprendre des mélanges de ces polymères et (co)polymères.

Les substrats organiques préférés dans le cadre de l'invention sont ceux présentant un coefficient de dilatation thermique de 50.10⁻⁶ °C⁻¹ à 180.10⁻⁶ °C⁻¹, et préférentiellement de 100.10⁻⁶ °C⁻¹ à 180.10⁻⁶ °C⁻¹.

Avant le dépôt de la sous-couche sur le substrat éventuellement revêtu, par exemple d'une couche anti-abrasion et/ou anti-rayures, il est courant de soumettre la surface dudit substrat, éventuellement revêtue, à un traitement d'activation physique ou chimique, destiné à augmenter l'adhésion de la sous-couche. Ce pré-traitement est généralement conduit sous vide. Il peut s'agir d'un bombardement avec des espèces énergétiques, par exemple un faisceau d'ions ("Ion Pre-Cleaning" ou "IPC") ou un faisceau d'électrons, d'un traitement par décharge corona, par effluvage, d'un traitement UV, ou d'un traitement par plasma sous vide, généralement un plasma d'oxygène ou d'argon. Il peut également s'agir d'un traitement de surface acide ou basique et/ou par solvants (eau ou solvant organique). Plusieurs de ces traitements peuvent être combinés. Grâce à ces traitements de nettoyage, la propreté de la surface du substrat est optimisée.

Par espèces énergétiques, on entend notamment des espèces ioniques ayant une énergie allant de 1 à 300 eV, préférentiellement de 1 à 150 eV, mieux de 10 à 150 eV, et mieux encore de 40 à 150 eV. Les espèces énergétiques peuvent être des espèces chimiques telles que des ions, des radicaux, ou des espèces telles que des photons ou des électrons.

Le pré-traitement préféré de la surface du substrat est un traitement par bombardement ionique, effectué au moyen d'un canon à ions, les ions étant des particules constituées d'atomes de gaz dont on a extrait un ou plusieurs électron(s). On utilise de préférence en tant que gaz ionisé l'argon (ions Ar⁺), mais également l'oxygène, ou leurs mélanges, sous une tension d'accélération allant généralement de 50 à 200 V, une densité de courant généralement comprise entre 10 et 100 µA/cm² sur la surface activée, et généralement sous une pression résiduelle dans l'enceinte à vide pouvant varier de 8.10⁻⁵ mbar à 2.10⁻⁴ mbar.

Selon la présente invention, une sous-couche est utilisée en combinaison avec un empilement multicouche comprenant au moins une couche de haut indice de réfraction et au moins une couche de bas indice de réfraction.

Par sous-couche, ou couche d'adhésion, on entend un revêtement qui est déposé sur le substrat (nu ou revêtu) avant le dépôt de l'empilement multicouche de l'invention. La sous-couche doit avoir une épaisseur suffisante pour promouvoir la résistance à l'abrasion du revêtement antireflet, mais de préférence pas trop importante pour ne pas avoir trop de contraintes totales et risquer des problèmes d'adhérence.

Compte tenu de son épaisseur relativement importante, la sous-couche ne participe généralement pas à la fonction optique anti-réfléchissante, en particulier dans le cas où elle possède un indice de réfraction proche du substrat nu, si la sous-couche est déposée sur le substrat nu, ou du revêtement si la sous-couche est déposée sur un substrat revêtu.

La sous-couche de l'invention est une sous-couche multicouche (laminée), de préférence bicouche. Dans ce dernier cas, elle ne contient pas d'autre couches que les deux couches adjacentes préférentiellement formées du même matériau et dont la somme des épaisseurs est supérieure ou égale à 75 nm.

La somme de ces épaisseurs est de préférence supérieure ou égale à 80 nm, mieux supérieure ou égale à 100 nm et encore mieux supérieure ou égale à 150 nm. La somme des épaisseurs de ces deux couches adjacentes est généralement inférieure à 250 nm, mieux inférieure à 200 nm.

La sous-couche du revêtement antireflet de l'invention comprend deux couches adjacentes préférentiellement de même nature chimique mais présentant des caractéristiques différentes obtenues en utilisant deux techniques de dépôt différentes.

Ainsi, la deuxième de ces deux couches adjacentes à être déposée présente une densité supérieure à celle de la première du fait qu'elle a été formée sous assistance ionique alors que la première de ces deux couches adjacentes à être déposée n'a pas été formée sous assistance ionique. Dans ce qui suit, la première de ces deux couches adjacentes à être déposée pourra être qualifiée de "couche inférieure" de la sous- couche, alors que la deuxième de ces deux couches adjacentes à être déposée pourra être qualifiée de "couche supérieure" de la sous-couche.

Ces deux couches adjacentes de la sous-couche sont de préférence formées du même matériau, ce qui signifie alors, dans le cadre de la présente demande, qu'elles ont été formées à partir du même matériau, par exemple par évaporation du même composé (ou du même mélange de composés).

La couche inférieure et la couche supérieure de la sous-couche sont de préférence des couches à base de SiO₂. Elles peuvent comprendre, en plus de la silice, un ou plusieurs autres matériaux conventionnellement utilisés pour la fabrication de sous-couches, par exemple un ou plusieurs matériaux choisis parmi les matériaux diélectriques décrits précédemment et ultérieurement dans la présente description. Ce sont de préférence des couches à base de SiO₂ exemptes d'Al₂O₃, et mieux, elles consistent en des couches de SiO₂.

La couche inférieure et la couche supérieure de la sous-couche de la présente invention comprennent de préférence au moins 70 % en masse de SiO₂, mieux au moins 80 % en masse et mieux encore au moins 90 % en masse de SiO₂. Comme il a été dit, dans une réalisation optimale, elles comprennent chacune 100 % en masse de silice.

Le ratio épaisseur de la couche inférieure de la sous-couche / épaisseur de la couche supérieure de la sous-couche varie de préférence de 9:1 à 1:9, mieux de 4:6 à 6:4. Selon le mode de réalisation présenté dans la partie expérimentale, ce ratio est de 1:1. Les épaisseurs mentionnées dans la présente demande sont des épaisseurs physiques, sauf indication contraire.

Lorsqu'elles sont formées du même matériau, la couche inférieure et la couche supérieure de la sous-couche peuvent être distinguées, notamment par analyse par microscopie électronique par transmission, par analyse par faisceau d'ions (RBS) ou le cas échéant mises en évidence par diffusion d'un matériau coloré, du fait de leurs porosités différentes.

La sous-couche selon l'invention comporte au moins les deux couches adjacentes précitées. Elle peut comporter d'autres couches, de préférence au plus trois autres couches, mieux au plus deux autres couches, intercalées entre le substrat éventuellement revêtu et lesdites deux couches adjacentes, en particulier si le substrat éventuellement revêtu présente un indice de réfraction élevé. Ces couches additionnelles sont de préférence de fines couches, dont la fonction est de limiter les réflexions à l'interface substrat / sous-couche (ou revêtement anti-abrasion et/ou anti-rayures / sous-couche, selon le cas).

Ainsi, lorsque le substrat possède un indice de réfraction élevé (terme par lequel on entend un indice de réfraction supérieur ou égal à 1,55, de préférence supérieur ou égal à 1,57) et que la sous-couche est déposée directement sur le substrat ou que le substrat est revêtu d'un revêtement anti-abrasion et/ou anti-rayures d'indice de réfraction élevé (c'est-à-dire supérieur ou égal à 1,55, de préférence supérieur ou égal à 1,57), préférentiellement à base d'époxysilanes, et que la sous-couche est déposée directement sur ce revêtement anti-abrasion et/ou anti-rayures, la sous-couche comprend préférentiellement, outre les deux couches adjacentes préférentiellement formées du même matériau et dont la somme des épaisseurs est supérieure ou égale à 75 nm, une couche d'indice de réfraction élevé et d'épaisseur inférieure ou égale à 80 nm, mieux inférieure ou égale à 50 nm et mieux encore inférieure ou égale à 30 nm. Cette couche d'indice de réfraction élevé est directement en contact avec le substrat d'indice élevé ou le revêtement anti-abrasion et/ou anti-rayures d'indice élevé. Bien entendu, ce mode de réalisation peut être utilisé même si le substrat (ou le revêtement anti-abrasion et/ou anti-rayures) possède un indice de réfraction inférieur à 1,55

En alternative, la sous-couche comprend, outre les deux couches adjacentes préférentiellement formées du même matériau et dont la somme des épaisseurs est supérieure ou égale à 75 nm et la couche d'indice de réfraction élevé précitée, une couche de matériau de bas indice de réfraction (c'est à dire inférieur ou égal à 1,55, de préférence inférieur ou égal à 1,52, mieux inférieur ou égal à 1,50) à base de SiO₂, exempte ou non d'Al₂O₃, d'épaisseur inférieure ou égale à 80 nm, mieux inférieure ou égale à 50 nm et mieux encore inférieure ou égale à 30 nm, sur laquelle est déposée ladite couche d'indice de réfraction élevé.

Typiquement, dans ce cas, la sous-couche comprend, déposées dans cet ordre à partir du substrat, une couche de 25 nm de SiO₂, une couche de 10 nm de ZrO₂, la couche dite "inférieure" de la sous-couche et la couche dite "supérieure" de la sous-couche.

Les différentes couches de la sous-couche sont préférentiellement déposées par évaporation sous vide.

L'opération d'IAD que subit la couche supérieure de la sous-couche peut être effectuée au moyen d'un canon à ions, les ions étant des particules constituées d'atomes de gaz dont on a extrait un ou plusieurs électron(s). Elle consiste préférentiellement en un bombardement de la surface à traiter par des ions oxygène, d'une densité de courant généralement comprise entre 10 et 200 µA/cm², de préférence entre 30 et 100 µA/cm² sur la surface activée et généralement sous une pression résiduelle dans l'enceinte à vide pouvant varier de 6.10⁻⁵ mbar à 2.10⁻⁴ mbar, préférentiellement de 8.10⁻⁵ mbar à 2.10⁻⁴ mbar. D'autres gaz ionisés peuvent être employés en combinaison ou non avec l'oxygène, comme par exemple l'argon, l'azote, notamment un mélange d'O₂ et d'argon dans un ratio volumique 2:1 à 1:2.

Il est recommandé que la couche inférieure de la sous-couche ne soit pas déposée sous assistance ionique. Dans le cas contraire, cela revient à déposer une sous-couche comprenant une seule couche d'épaisseur supérieure ou égale à 75 nm et de densité élevée, ce qui entraîne une diminution de l'adhésion de certaines couches du revêtement antireflet.

Sans vouloir être limités par une quelconque théorie, les inventeurs pensent que le dépôt d'une sous-couche d'épaisseur supérieure ou égale à 75 nm sous assistance ionique conduit à une sous-couche plus dense, ce qui peut conduire à une mise sous contrainte (compression) trop forte du revêtement antireflet et donc à une diminution de ses propriétés d'adhésion. Le fait de réaliser le dépôt de la sous-couche selon le procédé de l'invention permet d'augmenter la résistance à l'abrasion de l'article final tout en limitant l'augmentation de la contrainte en compression de façon à éviter un affaiblissement de la structure du revêtement antireflet.

La sous-couche de l'invention a une épaisseur totale supérieure ou égale à 75 nm, de préférence supérieure ou égale à 80 nm, mieux supérieure ou égale à 100 nm et encore mieux supérieure ou égale à 150 nm. Son épaisseur est généralement inférieure à 250 nm, mieux inférieure à 200 nm.

L'empilement multicouche du revêtement antireflet est de préférence déposé directement sur la surface exposée de la sous-couche, c'est-à-dire directement sur la surface exposée de la couche supérieure de la sous-couche.

De façon optionnelle, la surface exposée de la sous-couche peut être soumise, avant le dépôt de la première couche de l'empilement multicouche, à un traitement d'activation physique ou chimique pouvant être choisi parmi les pré-traitements auxquels le substrat peut être soumis avant le dépôt de la sous-couche et qui ont déjà été présentés ci-dessus. Le pré-traitement préféré est un bombardement ionique. Habituellement conduit sous vide, en utilisant par exemple un faisceau d'ions argon généré à l'aide d'un canon à ions, il permet généralement d'une part d'améliorer les propriétés de résistance à l'abrasion du revêtement antireflet, et d'autre part d'augmenter ses propriétés d'adhésion, en particulier l'adhésion de l'empilement multicouche à la sous-couche.

De tels traitements d'activation physique ou chimique peuvent également être réalisés sur la surface d'une ou plusieurs couches de l'empilement multicouche, en particulier sur la surface de l'avant dernière couche de cet empilement.

Dans la présente demande, une couche de l'empilement multicouche du revêtement antireflet (AR) est dite couche de haut indice de réfraction (HI) lorsque son indice de réfraction est supérieur à 1,55, de préférence supérieur ou égal à 1,6, de préférence encore supérieur ou égal à 1,7, mieux supérieur ou égal à 1,8 et encore mieux supérieur ou égal à 1,9. Une couche de l'empilement multicouche du revêtement antireflet est dite couche de bas indice de réfraction (BI) lorsque son indice de réfraction est inférieur ou égal à 1,55, de préférence inférieur ou égal à 1,52, mieux inférieur ou égal à 1,50.

Sauf indication contraire, les indices de réfraction auxquels il est fait référence dans la présente demande sont exprimés à 25 °C pour une longueur d'onde de 550 nm.

Les couches HI sont des couches de haut indice de réfraction classiques, bien connues dans la technique. Elles comprennent généralement un ou plusieurs oxydes minéraux tels que, sans limitation, la zircone (ZrO₂), l'oxyde de titane (TiO₂), le pentoxyde de tantale (Ta₂O₅), l'oxyde de néodyme (Nd₂O₅), l'oxyde de praséodyme (Pr₂O₃), le titanate de praséodyme (PrTiO₃), La₂O₃, Dy₂O₅, Nb₂O₅, Y₂O₃. Eventuellement, les couches haut indice peuvent contenir également de la silice ou de l'alumine, pourvu que leur indice de réfraction soit supérieur à 1,55, de préférence supérieur ou égal à 1,6, mieux supérieur ou égal à 1,7 et encore mieux supérieur ou égal à 1,9. Les matériaux préférés sont TiO₂, PrTiO₃, ZrO₂ et leurs mélanges.

Selon un mode de réalisation particulier de l'invention, au moins une couche Hl de l'empilement multicouche est une couche à base de TiO₂, dont l'indice de réfraction élevé est particulièrement intéressant. Elle est de préférence déposée sous assistance ionique (IAD), ce qui augmente la compression de cette couche et par là son indice de réfraction.

Selon un autre mode de réalisation particulier de l'invention, au moins une couche Hl de l'empilement multicouche est une couche à base de PrTiO₃, dont la résistance thermique élevée est particulièrement intéressante.

Les couches BI sont également bien connues et peuvent comprendre, sans limitation, SiO₂, MgF₂, ZrF₄, de l'alumine (Al₂O₃), AlF₃, de la chiolite (Na₃Al₃F₁₄]), de la cryolite (Na₃[AlF₆]), et leurs mélanges, de préférence SiO₂ ou SiO₂ dopé avec de l'alumine, lequel contribue à augmenter la résistance thermique du revêtement antireflet. On peut également utiliser des couches SiOF (SiO₂ dopé au fluor). Bien évidemment, les mélanges de ces composés avec optionnellement un ou plusieurs autres matériaux choisis parmi les matériaux diélectriques décrits précédemment dans la présente description sont tels que l'indice de réfraction de la couche résultante est tel que défini ci-dessus (≤ 1,55).

Lorsqu'une couche BI comprenant un mélange de SiO₂ et d'Al₂O₃ est utilisée, elle comprend préférentiellement de 1 à 10 %, mieux de 1 à 8 % et encore mieux de 1 à 5 % en masse d'Al₂O₃ par rapport à la masse totale de SiO₂ + Al₂O₃ dans cette couche. Une proportion trop importante d'alumine peut être défavorable à l'adhésion du revêtement AR.

Par exemple, SiO₂ dopé avec 4 % ou moins d'Al₂O₃ en masse, ou SiO₂ dopé avec 8 % d'Al₂O₃ peuvent être employés. Des mélanges SiO₂/Al₂O₃ disponibles dans le commerce peuvent être utilisés, tels que le LIMA^{®} commercialisé par Umicore Materials AG (indice de réfraction n = 1,48-1,50 à 550 nm), ou la substance L5^{®} commercialisée par Merck KGaA (indice de réfraction n = 1,48 à 500 nm).

Selon un mode de réalisation préférentiel, au moins une couche BI de l'empilement multicouche comprend un mélange de SiO₂ et d'Al₂O₃, de préférence consiste en un mélange de SiO₂ et d'Al₂O₃. Selon un autre mode de réalisation préférentiel, toutes les couches BI de l'empilement multicouche comprennent un mélange de SiO₂ et d'Al₂O₃, de préférence consistent en un mélange de SiO₂ et d'Al₂O₃. Dans ce dernier cas, il est particulièrement préférable que la couche supérieure et la couche inférieure de la sous-couche soient des couches à base de SiO₂ exemptes d'Al₂O₃.

Généralement, les couches HI ont une épaisseur physique variant de 10 à 120 nm, et les couches BI ont une épaisseur physique variant de 10 à 100 nm.

Préférentiellement, l'épaisseur totale du revêtement antireflet est inférieure à 1 micromètre, mieux inférieure ou égale à 800 nm et mieux encore inférieure ou égale à 500 nm. L'épaisseur totale du revêtement antireflet est généralement supérieure à 100 nm, de préférence supérieure à 150 nm.

De préférence encore, l'empilement multicouche comprend au moins deux couches de bas indice de réfraction (BI) et au moins deux couches de haut indice de réfraction (HI). Préférentiellement, le nombre total de couches de l'empilement multicouche est inférieur ou égal à 8, mieux inférieur ou égal à 6.

Il n'est pas nécessaire que les couches HI et BI soient alternées dans l'empilement, bien qu'elles puissent l'être selon un mode de réalisation de l'invention. Deux couches HI (ou plus) peuvent être déposées l'une sur l'autre, tout comme deux couches BI (ou plus) peuvent être déposées l'une sur l'autre. Ainsi, il est intéressant en termes de résistance à l'abrasion d'empiler l'une sur l'autre par exemple une couche HI de ZrO₂ et une couche HI de TiO₂ plutôt que d'utiliser une couche de TiO₂ à la place de ces deux couches HI adjacentes.

De préférence, la sous-couche est adjacente à une couche de haut indice de réfraction (HI) de l'empilement multicouche.

Selon une autre préférence, la couche externe de l'empilement multicouche, c'est-à-dire sa couche la plus éloignée du substrat, est une couche comprenant un mélange d'oxyde silicium et d'oxyde d'aluminium, dans des proportions préférentielles telles que celles décrites précédemment.

Les différentes couches de l'empilement multicouche, dites "couches optiques", sont préférentiellement déposées par dépôt sous vide selon l'une des techniques suivantes : i) par évaporation, éventuellement assistée par faisceau ionique ; ii) par pulvérisation par faisceau d'ion ; iii) par pulvérisation cathodique ; iv) par dépôt chimique en phase vapeur assisté par plasma. Ces différentes techniques sont décrites dans les ouvrages "Thin Film Processes" and "Thin Film Processes II," Vossen & Kern, Ed., Academic Press, 1978 et 1991 respectivement. Une technique particulièrement recommandée est la technique d'évaporation sous vide.

De préférence, le dépôt de chacune des couches du revêtement antireflet est réalisé par évaporation sous vide. Un tel procédé présente l'avantage d'éviter de chauffer le substrat, ce qui est particulièrement intéressant dans le cas des verres organiques.

Il est possible de réaliser une étape de traitement avec des espèces énergétiques telles que définies précédemment, de façon concomitante au dépôt d'une ou plusieurs des différentes couches de l'empilement multicouche. En particulier, le recours à une assistance ionique, de préférence par des ions oxygène, permet de tasser lesdites couches pendant qu'elles sont en train d'être formées.

De façon optionnelle, le dépôt d'une ou plusieurs couches de l'empilement multicouche et/ou de la sous-couche est effectué dans une enceinte sous vide avec apport de gaz pendant l'étape de dépôt. Concrètement, un gaz tel que, sans limitation, l'argon, l'oxygène ou leurs mélanges, est introduit dans l'enceinte de dépôt sous vide pendant le dépôt d'une couche.

Cette modification du procédé de dépôt de cette couche permet généralement de limiter les contraintes dans le revêtement antireflet et de renforcer l'adhésion des couches qui le composent. Lorsque cette technique de dépôt, nommée dépôt sous régulation de pression de gaz, est employée, on préfère employer une atmosphère d'oxygène (oxygène dit "passif").

Il est bien connu que les articles d'optique ont tendance à se charger en électricité statique, particulièrement lorsqu'ils sont nettoyés en conditions sèches par frottement de leur surface au moyen d'un chiffon, d'un morceau de mousse synthétique ou de polyester. Ils sont alors capables d'attirer et de fixer les petites particules se trouvant à proximité telles que les poussières, et ce durant tout le temps où la charge reste sur l'article. Il est bien connu dans l'état de la technique qu'un article peut acquérir des propriétés antistatiques grâce à la présence à sa surface d'une couche électriquement conductrice. Cette technique a été appliquée dans la demande internationale WO 01/55752 et le brevet EP 0834092. Cette couche permet une dissipation rapide de la charge.

Par "antistatique", on entend la propriété de ne pas retenir et/ou développer une charge électrostatique appréciable. Un article est généralement considéré comme ayant des propriétés antistatiques acceptables, lorsqu'il n'attire et ne fixe pas la poussière et les petites particules après que l'une de ses surfaces a été frottée au moyen d'un chiffon approprié.

Il existe différentes techniques pour quantifier les propriétés antistatiques d'un matériau.

Une de ces techniques consiste à prendre en compte le potentiel statique du matériau. Lorsque le potentiel statique du matériau (mesuré alors que l'article n'a pas été chargé) est de 0 KV +/- 0,1 KV (en valeur absolue), le matériau est antistatique, en revanche lorsque son potentiel statique est différent de 0 KV +/- 0,1 KV (en valeur absolue), le matériau est dit statique.

Selon une autre technique, la capacité d'un verre à évacuer une charge statique obtenue après frottement par un tissu ou par tout autre procédé de génération d'une charge électrostatique (charge appliquée par corona...) peut être quantifiée par une mesure du temps de dissipation de ladite charge. Ainsi, les verres antistatiques possèdent un temps de décharge de l'ordre de quelques centaines de millisecondes, préférentiellement 200 ms ou moins, alors qu'il est de l'ordre de plusieurs dizaines de secondes pour un verre statique.

L'article de l'invention peut être rendu antistatique grâce à l'incorporation d'au moins une couche électriquement conductrice dans l'empilement multicouche. La couche électriquement conductrice peut être localisée à différents endroits du revêtement antireflet, pourvu que ses propriétés anti-réfléchissantes ne soient pas perturbées. Elle peut par exemple être déposée sur la sous-couche de l'invention et constituer la première couche de l'empilement multicouche. Elle est de préférence localisée entre deux couches diélectriques de l'empilement multicouche, et/ou sous une couche de bas indice de réfraction de l'empilement multicouche.

La couche électriquement conductrice doit être suffisamment fine pour ne pas altérer la transparence du revêtement antireflet. Généralement, son épaisseur varie de 0,1 à 150 nm, mieux de 0,1 à 50 nm, selon sa nature. Une épaisseur inférieure à 0,1 nm ne permet généralement pas d'obtenir une conductivité électrique suffisante, alors qu'une épaisseur supérieure à 150 nm ne permet généralement pas d'obtenir les caractéristiques de transparence et de faible absorption requises.

La couche électriquement conductrice est de préférence fabriquée à partir d'un matériau électriquement conducteur et hautement transparent. Dans ce cas, son épaisseur varie de préférence de 0,1 à 30 nm, mieux de 1 à 20 nm et encore mieux de 1 à 15 nm. La couche électriquement conductrice comprend de préférence un oxyde métallique choisi parmi les oxydes d'indium, d'étain, de zinc et leurs mélanges. L'oxyde d'étain-indium (In₂O₃:Sn, oxyde d'indium dopé à l'étain) et l'oxyde d'étain (In₂O₃) sont préférés. Selon un mode de réalisation optimal, la couche électriquement conductrice et optiquement transparente est une couche d'oxyde d'étain-indium, notée couche d'ITO.

Généralement, la couche électriquement conductrice contribue à l'obtention de propriétés anti-réfléchissantes et constitue une couche de haut indice de réfraction dans le revêtement antireflet. C'est le cas de couches fabriquées à partir d'un matériau électriquement conducteur et hautement transparent telles que les couches d'ITO.

La couche électriquement conductrice peut également être une couche d'un métal noble (Ag, Au, Pt etc.) de très faible épaisseur, typiquement de moins de 1 nm d'épaisseur, mieux de moins de 0,5 nm.

De manière particulièrement avantageuse, l'empilement multicouche du revêtement antireflet comprend au moins quatre couches diélectriques, de préférence quatre ou cinq, et éventuellement une couche électriquement conductrice qui confère des propriétés antistatiques à l'article.

Selon un mode de réalisation préféré, le revêtement antireflet de l'invention comprend, dans l'ordre de dépôt sur la surface du substrat, une sous-couche bicouche de SiO₂ d'épaisseur supérieure ou égale à 75 nm conforme à l'invention, une couche de ZrO₂, généralement de 10 à 40 nm d'épaisseur et préférentiellement de 15 à 35 nm, une couche de SiO₂ ou de SiO₂/Al₂O₃, de préférence SiO₂/Al₂O₃, généralement de 10 à 40 nm d'épaisseur et préférentiellement de 15 à 35 nm, une couche de TiO₂, généralement de 40 à 150 nm d'épaisseur, préférentiellement de 50 à 120 nm, une couche de ZrO₂, généralement de 8 à 30 nm d'épaisseur et préférentiellement de 10 à 25 nm, éventuellement une couche électriquement conductrice, de préférence une couche d'ITO, généralement de 0,1 à 30 nm d'épaisseur, préférentiellement de 1 à 20 nm, et une couche de SiO₂ ou de SiO₂/Al₂O₃, de préférence SiO₂/Al₂O₃, généralement de 40 à 150 nm d'épaisseur, préférentiellement de 50 à 100 nm.

Il est préférable que l'empilement multicouche de l'invention comprenne une couche électriquement conductrice, et mieux, que l'article de l'invention comprenne un empilement TiO₂ / ZrO₂ / couche électriquement conductrice, la première couche citée étant la plus proche du substrat.

Selon un mode de réalisation particulièrement préféré, sont déposées successivement, depuis la surface du substrat éventuellement revêtu d'un ou plusieurs revêtements fonctionnels, une sous-couche conforme à l'invention de SiO₂ d'épaisseur supérieure ou égale à 120 nm consistant en deux couches adjacentes formées préférentiellement du même matériau, une couche de ZrO₂ de 20 à 30 nm d'épaisseur, une couche de SiO₂/Al₂O₃ de 20 à 30 nm d'épaisseur, une couche de TiO₂ de 75 à 110 nm d'épaisseur, une couche de ZrO₂ de 10 à 20 nm d'épaisseur, une couche d'ITO de 2 à 18 nm d'épaisseur, et une couche de SiO₂/Al₂O₃ de 60 à 90 nm d'épaisseur.

La couche électriquement conductrice, qui est généralement une couche de haut indice de réfraction de l'empilement antireflet, peut être déposée selon toute technique appropriée, par exemple par dépôt sous vide par évaporation, de préférence assistée par faisceau ionique (IAD), ou bien par une technique de pulvérisation cathodique ou par faisceau d'ion.

Lorsqu'elles sont présentes, les trois couches successives TiO₂ / ZrO₂ / couche électriquement conductrice (de préférence ITO) sont de préférence toutes trois déposées sous assistance ionique (IAD), de préférence sous assistance d'ions oxygène.

La sous-couche et l'empilement multicouche. peuvent être déposés directement sur un substrat nu. Dans certaines applications, il est préférable que la surface principale du substrat soit revêtue d'un ou plusieurs revêtements fonctionnels préalablement au dépôt du revêtement antireflet de l'invention. Ces revêtements fonctionnels classiquement utilisés en optique peuvent être, sans limitation, une couche de primaire antichoc, un revêtement anti-abrasion et/ou anti-rayures, un revêtement polarisé, un revêtement photochrome, un revêtement antistatique ou un revêtement coloré.

La sous-couche et l'empilement multicouche sont de préférence déposés sur un revêtement anti-abrasion et/ou anti-rayures. Le revêtement anti-abrasion et/ou anti-rayures peut être toute couche classiquement utilisée comme revêtement anti-abrasion et/ou anti-rayures dans le domaine des lentilles ophtalmiques.

Les revêtements résistant à l'abrasion et/ou aux rayures sont de préférence des revêtement durs à base de poly(méth)acrylates ou de silanes comprenant généralement une ou plusieurs charges minérales destinées à augmenter la dureté et/ou l'indice de réfraction du revêtement une fois durci

Les revêtements durs anti-abrasion et/ou anti-rayures sont de préférence élaborés à partir de compositions comprenant au moins un alcoxysilane et/ou un hydrolysat de celui-ci, obtenu par exemple par hydrolyse avec une solution d'acide chlorhydrique. Après l'étape d'hydrolyse, dont la durée est généralement comprise entre 1 h et 24h, préférentiellement entre 2h et 6h, des catalyseurs de condensation et/ou de durcissement peuvent optionnellement être ajoutés. Un composé tensioactif est de préférence également ajouté afin de favoriser la qualité optique du dépôt.

Parmi les revêtements recommandés dans la présente invention, on peut citer les revêtements à base d'hydrolysats d'époxysilanes tels que ceux décrits dans les brevets FR 2702486 (EP 0614957), US 4,211,823 et US 5,015,523.

De nombreux exemples de catalyseurs de condensation et/ou de durcissement utilisables sont donnés dans les ouvrages "Chemistry and Technology of the Epoxy Resins", B. Ellis (Ed.) Chapman Hall, New York, 1993 et "Epoxy Resins Chemistry and Technology" 2ème édition, C. A. May (Ed.), Marcel Dekker, New York, 1988.

Une composition pour revêtement anti-abrasion et/ou anti-rayures préférée est celle divulguée dans le brevet FR 2702486, au nom du déposant. Elle comprend un hydrolysat d'époxy trialcoxysilane et de dialkyl dialcoxysilane, de la silice colloïdale et une quantité catalytique de catalyseur de durcissement à base d'aluminium tel que l'acétylacétonate d'aluminium, le reste étant essentiellement constitué par des solvants classiquement utilisés pour la formulation de telles compositions. Préférentiellement, l'hydrolysat utilisé est un hydrolysat de γ-glycidoxypropyltriméthoxysilane (GLYMO) et de diméthyldiéthoxysilane (DMDES).

La composition de revêtement anti-abrasion et/ou anti-rayures peut être déposée sur la surface principale du substrat par trempage ou centrifugation. Elle est ensuite durcie par la voie appropriée (de préférence thermique, ou UV).

L'épaisseur du revêtement anti-abrasion et/ou anti-rayures varie généralement de 2 à 10 µm, préférentiellement de 3 à 5 µm.

Préalablement au dépôt du revêtement anti-abrasion et/ou anti-rayures, il est possible de déposer sur le substrat un revêtement de primaire améliorant la résistance aux chocs et/ou l'adhésion des couches ultérieures dans le produit final.

Ce revêtement peut être toute couche de primaire antichoc classiquement utilisée pour les articles en matériau polymère transparent, tels que des lentilles ophtalmiques.

Parmi les compositions de primaire préférées, on peut citer les compositions à base de polyuréthanes thermoplastiques, telles que celles décrites dans les brevets japonais JP 63-141001 et JP 63-87223, les compositions de primaire poly(méth)acryliques, telles que celles décrites dans le brevet US 5,015,523, les compositions à base de polyuréthanes thermodurcissables, telles que celles décrites dans le brevet EP 0404111 et les compositions à base de latex poly(méth)acryliques ou de latex de type polyuréthane, telles que celles décrites dans les brevets US 5,316,791 et EP 0680492.

Les compositions de primaire préférées sont les compositions à base de polyuréthanes et les compositions à base de latex, en particulier les latex de polyuréthane.

Les latex poly(méth)acryliques sont des latex de copolymères constitués principalement par un (méth)acrylate, tel que par exemple le (méth)acrylate d'éthyle, de butyle, de méthoxyéthyle ou d'éthoxyéthyle, avec une proportion généralement mineure d'au moins un autre co-monomère, tel que par exemple du styrène.

Les latex poly(méth)acryliques préférés sont les latex de copolymères acrylate-styrène. De tels latex de copolymères acrylate-styrène sont disponibles commercialement auprès de la société ZENECA RESINS sous la dénomination NEOCRYL^{®}.

Les latex de polyuréthane sont également connus et disponibles dans le commerce. A titre d'exemple, on peut citer les latex de polyuréthane contenant des motifs polyesters. De tels latex sont également commercialisés par la société ZENECA RESINS sous la dénomination NEOREZ^{®} et par la société BAXENDEN CHEMICALS sous la dénomination WITCOBOND^{®}.

Parmi les compositions de primaire commerciales convenant pour l'invention, on peut citer les compositions Witcobond^{®} 232, Witcobond^{e} 234, Witcobond^{®} 240, Witcobond^{®} 242, Neorez^{®} R-962, Neorez^{®} R-972, Neorez^{®} R-986 et Neorez^{®} R-9603.

On peut également utiliser dans les compositions de primaire des mélanges de ces latex, en particulier de latex polyuréthane et de latex poly(méth)acrylique.

Ces compositions de primaire peuvent être déposées sur les faces de l'article par trempage ou centrifugation puis séchées à une température d'au moins 70 °C et pouvant aller jusqu'à 100 °C, de préférence de l'ordre de 90 °C, pendant une durée de 2 minutes à 2 heures, généralement de l'ordre de 15 minutes, pour former des couches de primaire ayant des épaisseurs, après cuisson, de 0,2 à 2,5 µm, de préférence de 0,5 à 1,5 µm.

L'article d'optique selon l'invention peut également comporter des revêtements formés sur le revêtement antireflet et capables de modifier ses propriétés de surface, tels que des revêtements hydrophobes et/ou oléophobes (top coat anti-salissures). Ces revêtements sont de préférence déposés sur la couche externe du revêtement antireflet. Leur épaisseur est en général inférieure ou égale à 10 nm, de préférence de 1 à 10 nm, mieux de 1 à 5 nm.

Il s'agit généralement de revêtements de type fluorosilane ou fluorosilazane. Ils peuvent être obtenus par dépôt d'un fluorosilane ou fluorosilazane précurseur, comprenant de préférence au moins deux groupes hydrolysables par molécule. Les fluorosilanes précurseurs contiennent préférentiellement des groupements fluoropolyéthers et mieux des groupements perfluoropolyéthers. Ces fluorosilanes sont bien connus et sont décrits, entre autres, dans les brevets US 5,081,192, US 5,763,061, US 6,183, 872, US 5,739, 639, US 5,922,787, US 6,337,235, US 6,277,485 et EP 0933377.

Une composition de revêtement hydrophobe et/ou oléophobe préférée est commercialisée par Shin-Etsu Chemical sous la dénomination KP 801M^{®}. Une autre composition de revêtement hydrophobe et/ou oléophobe préférée est commercialisée par Daikin Industries sous la dénomination OPTOOL DSX^{®}. Il s'agit d'une résine fluorée comprenant des groupes perfluoropropylène.

Typiquement, un article d'optique selon l'invention comprend un substrat successivement revêtu d'une couche de primaire antichoc, d'une couche anti-abrasion et/ou anti-rayures, d'une sous-couche selon l'invention, d'un empilement antireflet multicouche et d'un revêtement hydrophobe et/ou oléophobe. L'article selon l'invention est de préférence une lentille optique, mieux une lentille ophtalmique pour lunettes, ou une ébauche de lentille optique ou ophtalmique. La lentille peut être une lentille polarisée ou une lentille photochromique.

Grâce à sa sous-couche obtenue conformément au procédé de l'invention, l'article d'optique selon l'invention possède des propriétés de résistance à l'abrasion accrues par rapport au même article dont la sous-couche a été déposée de façon classique. Ces propriétés anti-abrasion peuvent être évaluées au moyen du test BAYER ASTM, décrit dans la partie expérimentale.

Les articles d'optique selon l'invention présentent de préférence une valeur BAYER ASTM supérieure ou égale à 4,5 selon la norme ASTM F 735.81, mieux supérieure ou égale à 5 et encore mieux supérieure ou égale à 5,2.

Les différentes couches du revêtement antireflet présentent de bonnes propriétés d'adhésion, en particulier à l'interface avec le substrat. Les propriétés d'adhésion de l'ensemble du revêtement antireflet au substrat ont été vérifiées au moyen du test communément appelé "nx10 coups", en suivant la procédure décrite dans la demande internationale WO 99/49097.

L'article d'optique selon l'invention possède une résistance thermique élevée, mesurée par sa température critique, définie comme étant celle à partir de laquelle on observe l'apparition de craquelures dans le revêtement antireflet. La température critique d'un article selon l'invention est de préférence supérieure ou égale à 80 °C, mieux supérieure ou égale à 85 °C et encore mieux supérieure ou égale à 90 °C.

L'article d'optique selon l'invention n'absorbe pas dans le visible ou absorbe peu dans le visible, ce qui signifie, au sens de la présente demande, que son facteur de transmission dans le visible τᵥ, encore nommé facteur relatif de transmission dans le visible, est supérieur à 90 %, mieux supérieur à 95 %, mieux encore supérieur à 96 % et de façon optimale supérieure à 97 %.

Le facteur τv répond à une définition internationale normalisée (norme ISO 13666:1998) et est mesuré conformément à la norme ISO 8980-3. Il est défini dans la gamme de longueur d'onde allant de 380 à 780 nm.

De préférence, l'absorption lumineuse de l'article revêtu selon l'invention est inférieure ou égale à 1 %. De préférence encore, le facteur moyen de réflexion dans le domaine visible (400-700 nm) d'un article revêtu d'un revêtement antireflet selon l'invention, noté Rₘ, est inférieur à 2,5 % par face, mieux inférieur à 2 % par face et encore mieux inférieur à 1 % par face de l'article. Dans un mode de réalisation optimal, l'article comprend un substrat dont les deux surfaces principales sont revêtues d'un revêtement antireflet selon l'invention et présente une valeur de Rₘ totale (cumul de réflexion due aux deux faces) inférieure à 1%, de préférence comprise entre 0,7 et 0,8 %. Les moyens pour parvenir à de telles valeurs de Rₘ sont bien connus de l'homme du métier.

Dans la présente demande, le "facteur moyen de réflexion" est tel que défini dans la norme ISO 13666:1998, et mesuré conformément à la norme ISO 8980-4, c'est-à-dire qu'il s'agit de la moyenne de la réflexion spectrale sur l'ensemble du spectre visible entre 400 et 700 nm.

Les exemples suivants illustrent l'invention de façon plus détaillée mais non limitative.

### EXEMPLES

### 1. Procédures générales

Les articles d'optique employés dans les exemples comprennent un substrat de lentille ORMA^{®} ESSILOR de 65 mm de diamètre, de puissance -2,00 dioptries et d'épaisseur 1,2 mm, revêtu (sauf exemple C2) d'un revêtement de primaire antichoc à base d'un latex polyuréthane contenant des motifs polyester, durci à 90 °C pendant 1 heure (Witcobond^{®} 234 de BAXENDEN CHEMICALS modifié par dilution afin de diminuer sa viscosité, dépôt centrifuge à 1500 tours/minute pendant 10 à 15 secondes) puis du revêtement anti-abrasion et anti-rayures (hard coat) divulgué dans l'exemple 3 du brevet EP 0614957 (d'indice de réfraction égal à 1,50), à base d'un hydrolysat de GLYMO et DMDES, de silice colloïdale et d'acétylacétonate d'aluminium, d'un revêtement antireflet et enfin d'un revêtement anti-salissures.

Ledit revêtement anti-abrasion et anti-rayures a été obtenu par dépôt et durcissement d'une composition comprenant en masse, 224 parties de GLYMO, 80,5 parties de HCl 0,1 N, 120 parties de DMDES, 718 parties de silice colloïdale à 30 % massique dans le méthanol, 15 parties d'acétylacétonate d'aluminium et 44 parties d'éthylcellosolve. La composition comporte également 0,1 % de tensioactif FLUORAD™ FC-430^{®} de 3M en masse par rapport à la masse totale de la composition.

Les couches de la sous-couche et de l'empilement multicouche du revêtement antireflet ont été déposées sans chauffage des substrats par évaporation sous vide, éventuellement, lorsque précisé, assistée par faisceau ionique et/ou avec apport d'oxygène pendant le dépôt (source d'évaporation : canon à électrons).

Le mélange SiO₂/Al₂O₃ utilisé dans les exemples est la substance L5^{®} commercialisée par Merck KGaA. Les couches antistatiques sont formées d'oxyde d'étain-indium (ITO) fourni par Optron Inc.

Le revêtement anti-salissures a été obtenu par évaporation sous vide du composé OF110 fourni par la société Optron Inc. (épaisseur : 2-5 nm)

Le bâti de dépôt est une machine Leybold 1104 équipé d'un canon à électrons ESV14 (8kV) pour l'évaporation des oxydes, d'un creuset à effet Joule pour le dépôt du top coat et d'un canon à ions type End-Hall (KRI pour les exemples 1, 2 et C1, Commonwealth Mark Il pour l'exemple C2) pour la phase préliminaire de préparation de la surface du substrat par des ions argon (IPC) et éventuellement celle de la sous-couche (seulement exemple C1), ainsi que pour les dépôts de couches sous assistance ionique.

L'épaisseur des couches est contrôlée au moyen d'une microbalance à quartz.

### 2. Modes opératoires

Le procédé de préparation des articles d'optique comprend l'introduction du substrat revêtu d'un revêtement de primaire (sauf exemple C2) et d'un revêtement anti-abrasion dans une enceinte de dépôt sous vide, une étape de pompage jusqu'à l'obtention d'un vide secondaire, une étape d'activation de la surface du substrat par un faisceau d'ions argon (IPC : 2 minutes, 18 cm³/min, 3 A pour les exemples 1, 2 et C1 ; 2 minutes, 13 sccm, 2,5 A pour l'exemple C2), l'arrêt de l'irradiation ionique, l'évaporation successive du nombre requis de couches du revêtement antireflet, une étape de dépôt du revêtement anti-salissures (top coat) et enfin une étape de ventilation.

### Formation du revêtement antireflet selon le procédé de l'invention (exemples 1 et 2)

La formation du revêtement antireflet de l'invention comprend :
- le dépôt d'une sous-couche bicouche en SiO₂ comprenant : i) le dépôt sur le substrat revêtu d'une première couche de SiO₂ avec une vitesse de 1 nm/s (sans assistance ionique) jusqu'à l'obtention d'une épaisseur de 75 nm (contrôle par microbalance à quartz). L'obturateur du canon à électrons est fermé et l'évaporation arrêtée; ii) le dépôt sur cette première couche d'une deuxième couche de SiO₂ avec une vitesse de 1 nm/s sous assistance d'ions oxygène (correspondant à 15 cm³/min - 2 A). Le dépôt de cette deuxième couche est réalisé en amorçant le canon à ions, de préférence avec le débit d'oxygène choisi. Une fois le faisceau d'ions créé et stabilisé, les granulés de silice sont à nouveau préchauffés avec le canon à électrons, et l'obturateur du canon à éléctrons est ouvert pour déposer une épaisseur de silice de 75 nm, avec bombardement ionique simultané. L'obturateur du canon à électrons est fermé, et l'évaporation et le bombardement ionique sont arrêtés.
- le dépôt d'un empilement antireflet multicouche comprenant le dépôt de la 1^{ère} couche Hl(ZrO₂) avec une vitesse de 0,3 nm/s, le dépôt de la 1^{ère} couche BI (SiO₂/Al₂O₃) avec une vitesse de 0,7 nm/s, le dépôt de la 2^{nde} couche HI (TiO₂, à partir de granulés préfondus) avec une vitesse de 0,3-0,5 nm/s et une assistance d'ions oxygène (correspondant à 15 cm³/min - 2 A pour l'exemple 1 et 18 cm³/min - 3 A pour l'exemple 2), le dépôt d'une 3^{ème} couche HI (ZrO₂) avec une vitesse de 0,30 nm/s et une assistance d'ions oxygène (correspondant à 15 cm³/min - 2 A), le dépôt d'une couche d'ITO avec une vitesse de 0,2-0,5 nm/s et une assistance d'ions oxygène (correspondant à 15 cm³/min - 2 A), et enfin le dépôt de la 2^{nde} couche BI (SiO₂/Al₂O₃) avec une vitesse de 1 nm/s.

### Formation du revêtement antireflet dans les exemples comparatifs C1 et C2

La formation du revêtement antireflet comprend une étape de dépôt sur le substrat revêtu de la sous-couche en SiO₂ avec une vitesse de 1 nm/s, sous atmosphère de O₂ à une pression de 1,5.10⁻⁴ mBar (seulement exemple C1), optionnellement une étape d'activation de la surface de la sous-couche au moyen d'un faisceau d'ions argon (traitement identique à celui d'IPC déjà opéré directement sur le substrat, uniquement exemple C1), l'arrêt de l'irradiation ionique, le dépôt de la 1^{ère} couche HI (ZrO₂) avec une vitesse de 0,3 nm/s, le dépôt de la 1^{ère} couche BI (SiO₂/Al₂O₃) avec une vitesse de 0,7 nm/s, le dépôt de la 2^{nde} couche HI (TiO₂, à partir de granulés préfondus) avec une vitesse de 0,3-0,5 nm/s, une assistance d'ions oxygène (correspondant à 18 cm³/min - 3 A pour C1 et 2,5 A - 120 V pour C2), et optionnellement sous atmosphère de O₂ (à une pression de 1.10⁻⁴ mBar, seulement exemple C2), le dépôt d'une 3^{ème} couche HI (ZrO₂) avec une vitesse de 0,3 nm/s et optionnellement une assistance d'ions oxygène (correspondant à 15 cm³/min - 2 A, seulement exemple C1), le dépôt d'une couche d'ITO avec une vitesse de 0,2-0,5 nm/s et une assistance d'ions oxygène (correspondant à 15 cm³/min - 2 A pour C1 et 2,5 A - 120 V pour C2), et enfin le dépôt de la 2^{nde} couche BI (SiO₂/Al₂O₃) avec une vitesse de 1 nm/s.

La constitution des articles d'optique obtenus selon les exemples 1, 2 et les exemples comparatifs C1 et C2 est détaillée ci-dessous :

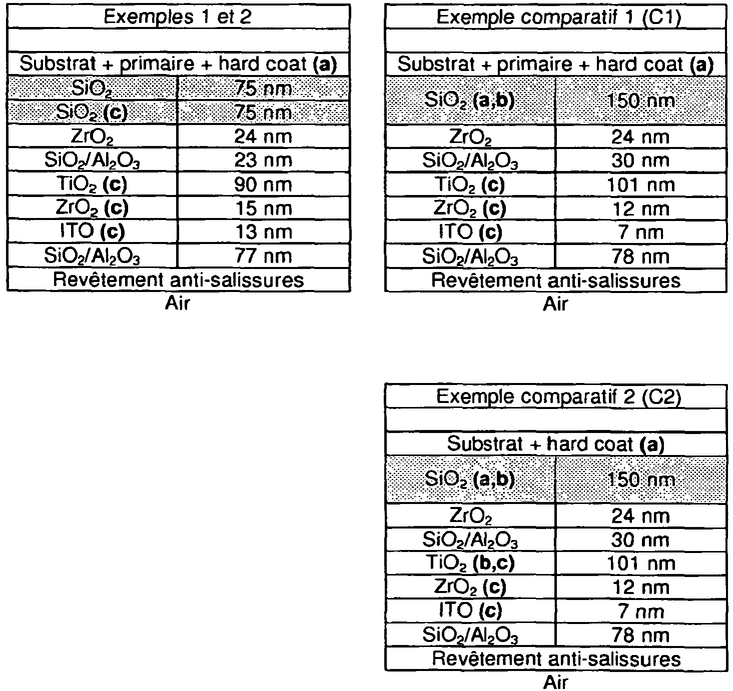

La sous-couche apparaît en grisé.
(a) Traitement de bombardement ionique de la surface de la couche avant le dépôt de la couche ultérieure.
(b) Apport d'oxygène pendant le dépôt.
(c) Dépôt de la couche sous assistance ionique.

### 3. Caractérisation de la résistance à l'abrasion

La résistance à l'abrasion des articles préparés a été évaluée par détermination de valeurs BAYER en réalisant le test BAYER ASTM (Bayer sable) conformément à la norme ASTM F 735.81. Une valeur élevée au test BAYER ASTM indique un degré élevé de résistance à l'abrasion. La valeur Bayer sable est qualifiée de bonne lorsque R est compris entre 3,4 et 4,5, et d'excellente pour des valeurs de 4,5 et plus.

Ce test consiste à agiter simultanément un verre échantillon et un verre étalon d'un mouvement alternatif déterminé dans un bac contenant une poudre abrasive (approximativement 500 g de sable) de granulométrie définie à une fréquence de 100 cycles/minute pendant 2 minutes. La mesure de diffusion H "avant / après" du verre échantillon est comparée à celle d'un verre étalon, en l'occurrence un verre nu à base de CR-39^{®}, pour lequel la valeur BAYER est fixée à 1. La valeur Bayer sable est R = H étalon/H verre échantillon.

Les mesures de diffusion ont été effectuées en utilisant un système Hazeguard modèle XL-211 produit par Pacific Scientific.

### 4. Résultats

Les résultats des mesures de résistance à l'abrasion sont regroupés dans le tableau 1 ci-dessous.

**Tableau 1**

| Exemple | Test Bayer ASTM (BAYER SABLE) |
|---|---|
| 1 | 6,0 |
| 2 | 5,4 |
| Comparatif 1 | 4,7 |
| Comparatif 2 | 4,8 |

Les lentilles des exemples 1 et 2 possèdent une meilleure résistance à l'abrasion que celles des exemples comparatifs.

## Revendications

1. Article d'optique à propriétés antireflet, comprenant un substrat ayant au moins une surface principale revêtue d'un revêtement antireflet comprenant, en partant du substrat :
- une sous-couche comprenant deux couches adjacentes, la somme des épaisseurs de ces deux couches adjacentes étant supérieure ou égale à 75 nm ; et
- un empilement antireflet multicouche comprenant au moins une couche de haut indice de réfraction et au moins une couche de bas indice de réfraction,
**caractérisé en ce que** le dépôt de la première desdites deux couches adjacentes de la sous-couche a été réalisé sans assistance ionique, **en ce que** le dépôt de la deuxième desdites deux couches adjacentes de la sous-couche a été réalisé sous assistance ionique, et **en ce que** la sous-couche est déposée sur un revêtement anti-abrasion et/ou anti-rayure.

2. Article selon la revendication 1, **caractérisé en ce que** le ratio d'épaisseur desdites deux couches adjacentes de la sous-couche varie de 9:1 à 1:9, de préférence de 4:6 à 6:4.

3. Article selon l'une quelconque des revendications précédentes, **caractérisé en ce que** la somme des épaisseurs desdites deux couches adjacentes est supérieure ou égale à 80 nm, de préférence supérieure ou égale à 100 nm et mieux supérieure ou égale à 150 nm.

4. Article selon l'une quelconque des revendications précédentes, **caractérisé en ce que** lesdites deux couches adjacentes de la sous-couche sont des couches à base de SiO₂, de préférence exemptes d'Al₂O₃, mieux consistent en des couches de SiO₂.

5. Article selon l'une quelconque des revendications précédentes, **caractérisé en ce que** la sous-couche comprend, outre lesdites deux couches adjacentes, au plus trois couches intercalées entre le substrat et lesdites deux couches adjacentes.

6. Article selon l'une quelconque des revendications précédentes, **caractérisé en ce qu'**il présente une valeur BAYER ASTM supérieure ou égale à 4,5 selon la norme ASTM F 735.81, de préférence supérieure ou égale à 5 et mieux supérieure ou égale à 5,2.

7. Article selon l'une quelconque des revendications précédentes, **caractérisé en ce que** toutes les couches de bas indice de réfraction de l'empilement multicouches comprennent un mélange de SiO₂ et d'Al₂O₃, de préférence consistent en un mélange de SiO₂ et d'Al₂O₃.

8. Article selon l'une quelconque des revendications précédentes, **caractérisé en ce qu'**il est une lentille optique, de préférence une lentille ophtalmique.

9. Article selon l'une quelconque des revendications précédentes, **caractérisé en ce que** ladite sous-couche comprend deux couches adjacentes formées du même matériau, la somme des épaisseurs de ces deux couches adjacentes étant supérieure ou égale à 75 nm.

10. Article selon l'une quelconque des revendications précédentes, **caractérisé en ce que** la sous-couche est adjacente à une couche de haut indice de réfraction de l'empilement antireflet multicouche.

11. Article selon l'une quelconque des revendications précédentes, **caractérisé en ce que** la somme des épaisseurs desdites deux couches adjacentes de la sous-couche est inférieure à 250 nm.

12. Article selon l'une quelconque des revendications précédentes, **caractérisé en ce que** la couche supérieure de la sous-couche est une couche à base de SiO₂, de préférence exempte d'Al₂O₃, mieux consiste en une couche de SiO₂.

13. Article selon l'une quelconque des revendications précédentes, **caractérisé en ce que** l'épaisseur du revêtement anti-abrasion et/ou anti-rayure varie de 2 à 10 µm.

14. Article selon l'une quelconque des revendications précédentes, **caractérisé en ce que** le revêtement anti-abrasion et/ou anti-rayure est à base d'hydrolysats d'époxysilanes.

15. Procédé de fabrication d'un article d'optique à propriétés antireflet, comprenant au moins les étapes suivantes :
- fournir un article d'optique comprenant un substrat ayant au moins une surface principale;
- déposer sur une surface principale du substrat une sous-couche ayant une surface exposée, ladite sous-couche comprenant deux couches adjacentes, préférentiellement formées du même matériau, la somme des épaisseurs de ces deux couches adjacentes étant supérieure ou égale à 75 nm;
- déposer sur ladite surface exposée de la sous-couche un empilement antireflet multicouche comprenant au moins une couche de haut indice de réfraction et au moins une couche de bas indice de réfraction,
- récupérer un article d'optique comprenant un substrat ayant une surface principale revêtue d'un revêtement antireflet comprenant ladite sous-couche et ledit empilement multicouche,
**caractérisé en ce que** le dépôt de la première desdites deux couches adjacentes de la sous-couche est réalisé sans assistance ionique, **en ce que** le dépôt de la deuxième desdites deux couches adjacentes de la sous-couche est réalisé sous assistance ionique, et **en ce que** la sous-couche est déposée sur un revêtement anti-abrasion et/ou anti-rayure.

16. Procédé selon la revendication 15, **caractérisé en ce que** lesdites deux couches adjacentes de la sous-couche sont des couches à base de SiO₂, de préférence exemptes d'Al₂O₃, mieux consistent en des couches de SiO₂.

## Patentansprüche

1. Optischer Artikel mit Antireflexionseigenschaften, der ein Substrat umfasst, das wenigstens eine Hauptoberfläche besitzt, die mit einer Antireflexionsbeschichtung beschichtet ist und ausgehend von dem Substrat Folgendes umfasst:
- eine Unterschicht, die zwei benachbarte Schichten umfasst, wobei die Summe der Dicken dieser zwei benachbarten Schichten größer oder gleich 75 nm ist; und
- einen Mehrschicht-Antireflexionsstapel, der wenigstens eine Schicht mit hohem Brechungsindex und wenigstens eine Schicht mit niedrigem Brechungsindex umfasst,
**dadurch gekennzeichnet, dass** der Niederschlag der ersten der zwei benachbarten Schichten der Unterschicht ohne ionische Unterstützung verwirklicht worden ist, dass der Niederschlag der zweiten dieser benachbarten Schichten der Unterschicht mit ionischer Unterstützung verwirklicht worden ist und dass die Unterschicht auf einer Abriebverhinderungs- und/oder Kratzverhinderungsbeschichtung abgelagert ist.

2. Artikel nach Anspruch 1, **dadurch gekennzeichnet, dass** das Verhältnis der Dicken der zwei benachbarten Schichten der Unterschicht im Bereich von 9:1 bis 1:9, vorzugsweise von 4:6 bis 6:4, variiert.

3. Artikel nach einem der vorhergehenden Ansprüche, **dadurch gekennzeichnet, dass** die Summe der Dicken der zwei benachbarten Schichten größer oder gleich 80 nm, vorzugsweise größer oder gleich 100 nm und am besten größer oder gleich 150 nm ist.

4. Artikel nach einem der vorhergehenden Ansprüche, **dadurch gekennzeichnet, dass** die zwei benachbarten Schichten der Unterschicht Schichten auf SiO₂-Basis sind, vorzugsweise mit Ausnahme von Al₂O₃, und am besten aus SiO₂-Schichten bestehen.

5. Artikel nach einem der vorhergehenden Ansprüche, **dadurch gekennzeichnet, dass** die Unterschicht außer den zwei benachbarten Schichten höchstens drei Schichten umfasst, die zwischen das Substrat und die zwei benachbarten Schichten eingefügt sind.

6. Artikel nach einem der vorhergehenden Ansprüche, **dadurch gekennzeichnet, dass** er einen BAYER ASTM-Wert größer oder gleich 4,5 gemäß der ASTM F 735.81-Norm, vorzugsweise größer oder gleich 5 und am besten größer oder gleich 5,2 aufweist.

7. Artikel nach einem der vorhergehenden Ansprüche, **dadurch gekennzeichnet, dass** alle Schichten mit niedrigem Brechungsindex des Mehrschichtstapels ein Gemisch aus SiO₂ und Al₂O₃ umfassen und vorzugsweise aus einem Gemisch aus SiO₂ und Al₂O₃ bestehen.

8. Artikel nach einem der vorhergehenden Ansprüche, **dadurch gekennzeichnet, dass** er eine optische Linse, vorzugsweise eine Augenlinse, ist.

9. Artikel nach einem der vorhergehenden Ansprüche, **dadurch gekennzeichnet, dass** die Unterschicht zwei benachbarte Schichten umfasst, die aus demselben Material gebildet sind, wobei die Summe der Dicken dieser zwei benachbarten Schichten größer oder gleich 75 nm ist.

10. Artikel nach einem der vorhergehenden Ansprüche, **dadurch gekennzeichnet, dass** die Unterschicht an eine Schicht mit hohem Brechungsindex des Mehrschicht-Antireflexionsstapels angrenzt.

11. Artikel nach einem der vorhergehenden Ansprüche, **dadurch gekennzeichnet, dass** die Summe der Dicken der zwei benachbarten Schichten der Unterschicht kleiner als 250 nm ist.

12. Artikel nach einem der vorhergehenden Ansprüche, **dadurch gekennzeichnet, dass** die obere Schicht der Unterschicht eine Schicht auf SiO₂-Basis ist, vorzugsweise mit Ausnahme von Al₂O₃, und am besten aus einer SiO₂-Schicht besteht.

13. Artikel nach einem der vorhergehenden Ansprüche, **dadurch gekennzeichnet, dass** die Dicke der Abriebverhinderungs- und/oder Kratzverhinderungsbeschichtung im Bereich von 2 bis 10 µm variiert.

14. Artikel nach einem der vorhergehenden Ansprüche, **dadurch gekennzeichnet, dass** die Abriebverhinderungs- und/oder Kratzverhinderungsbeschichtung eine Beschichtung auf Epoxidsilan-Hydrolysat-Basis ist.

15. Verfahren zur Herstellung eines optischen Artikels mit Antireflexionseigenschaften, das wenigstens die folgenden Schritte umfasst:
- Bereitstellen eines optischen Artikels, der ein Substrat umfasst, das wenigstens eine Hauptoberfläche besitzt;
- Ablagern auf einer Hauptoberfläche des Substrats einer Unterschicht, die eine freiliegende Oberfläche besitzt, wobei die Unterschicht zwei benachbarte Schichten umfasst, die vorzugsweise aus demselben Material gebildet sind, wobei die Summe der Dicken dieser zwei benachbarten Schichten größer oder gleich 75 nm ist;
- Ablagern auf der freiliegenden Oberfläche der Unterschicht eines Mehrschicht-Antireflexionsstapels, der wenigstens eine Schicht mit hohem Brechungsindex und wenigstens eine Schicht mit niedrigem Brechungsindex umfasst,
- Wiedergewinnen eines optischen Artikels, der ein Substrat umfasst, das eine Hauptoberfläche besitzt, die mit einer Antireflexionsbeschichtung beschichtet ist, die die Unterschicht und den Mehrschichtstapel enthält,
**dadurch gekennzeichnet, dass** die Ablagerung der ersten der zwei benachbarten Schichten der Unterschicht ohne ionische Unterstützung verwirklicht wird, dass die Ablagerung der zweiten der benachbarten Schichten der Unterschicht mit ionischer Unterstützung verwirklicht wird und dass die Unterschicht auf einer Abriebverhinderungs- und/oder Kratzverhinderungsbeschichtung abgelagert wird.

16. Verfahren nach Anspruch 15, **dadurch gekennzeichnet, dass** die zwei benachbarten Schichten der Unterschicht Schichten auf SiO₂-Basis sind, vorzugsweise mit Ausnahme von Al₂O₃, und am besten aus SiO₂-Schichten bestehen.

## Claims

1. An optical article provided with antireflection properties, comprising a substrate having at least one main surface coated with an antireflection coating comprising, starting from the substrate:
- a sub-layer comprising two adjacent layers, the sum of the thicknesses of the two adjacent layers being greater than or equal to 75 nm; and
- a multilayered antireflection stack comprising at least one high refractive index layer and at least one low refractive index layer,
wherein the deposition of the first of said two adjacent layers of the sub-layer has been carried out without ion assistance, the deposition of the second of said two adjacent layers of the sub-layer has been carried out under ion assistance, and the sub-layer is deposited onto an abrasion- and/or scratch-resistant coating.

2. An article according to claim 1, wherein the thickness ratio of the two adjacent layers of the sub-layer ranges from 9:1 to 1:9, preferably from 4:6 to 6:4.

3. An article according to any one of the preceding claims, wherein the sum of the thicknesses of said two adjacent layers is greater than or equal to 80 nm, preferably is greater than or equal to 100 nm and more preferably is greater than or equal to 150 nm.

4. An article according to any one of the preceding claims, wherein the two adjacent layers of the sub-layer are SiO₂-based layers preferably free of Al₂O₃, more preferably consist of SiO₂ layers.

5. An article according to any one of the preceding claims, wherein the sub-layer comprises, in addition to said two adjacent layers, at most three layers interleaved between the substrate and said two adjacent layers.

6. An article according to any one of the preceding claims, which has an ASTM BAYER value greater than or equal to 4.5 according to the standard ASTM F 735.81, preferably greater than or equal to 5 and more preferably greater than or equal to 5.2.

7. An article according to any one of the preceding claims, wherein all the low refractive index layers of the multilayered stack comprise a mixture of SiO₂ and Al₂O₃, and preferably consist in a mixture of SiO₂ and Al₂O₃.

8. An article according to any one of the preceding claims, which is an optical lens, preferably an ophthalmic lens.

9. An article according to any one of the preceding claims, wherein said sub-layer comprises two adjacent layers formed from the same material, the sum of the thicknesses of these two adjacent layers being higher than or equal to 75 nm.

10. An article according to any one of the preceding claims, wherein the sub-layer is adjacent to a high refractive index layer of the multilayer antireflection stack.

11. An article according to any one of the preceding claims, wherein the sum of the thicknesses of said two adjacent layers of the sub-layer is lower than 250 nm.

12. An article according to any one of the preceding claims, wherein the higher layer of the sub-layer is an SiO₂ based layer, preferably free of Al₂O₃, more preferably consisting of an SiO₂ layer.

13. An article according to any one of the preceding claims, wherein the thickness of the abrasion- and/or scratch-resistant coating ranges from 2 to 10 µm.

14. An article according to any one of the preceding claims, wherein the abrasion- and/or scratch-resistant coating is based on epoxysilane hydrolyzates.

15. A process for manufacturing an optical article provided with antireflection properties, comprising:
- providing an optical article comprising a substrate having at least one main surface;
- depositing onto a main surface of the substrate a sub-layer having an exposed surface, where said sub-layer comprises two adjacent layers which are preferably formed from the same material, the sum of the thicknesses of the two adjacent layers being greater than or equal to 75 nm;
- depositing onto said exposed surface of the sub-layer a multilayered antireflection stack comprising at least one high refractive index layer and at least one low refractive index layer,
- recovering an optical article comprising a substrate having one main surface coated with an antireflection coating comprising said sub-layer and said multilayered stack,
wherein the deposition of the first of said two adjacent layers of the sub-layer is carried out without ion assistance, the deposition of the second of said two adjacent layers of the sub-layer is carried out under ion assistance, and the sub-layer is deposited onto an abrasion- and/or scratch-resistant coating.

16. A process according to claim 15, wherein said two adjacent layers of the sub-layer are SiO₂-based layers, preferably free of Al₂O₃, more preferably consist of SiO₂ layers.
